# DEMANDE DE BREVET EUROPEEN

(11) **EP 2 595 190 A1**
(43) Date de publication de la demande: **22.05.2013**
(21) Numéro de dépôt: 12354048.6
(22) Date de dépôt: 15.11.2012
(51) Int. Cl.: H01L 27/146, H01L 31/0352

(54) **Dispositif de détection de deux couleurs différentes à conditions de fonctionnement améliorées**

(30) Priorité: 15.11.2011 FR 1103469
(71) Demandeur: Société Française de Détecteurs Infrarouges - SOFRADIR, 92290 Châtenay Malabry (FR)
(72) Inventeur: Chabuel, Fabien, 38130 Echirolles (FR); Rubaldo, Laurent, 38600 Fontaine (FR)
(74) Mandataire: Talbot, Alexandre

(57) **Abrégé**

Le substrat (3) comporte successivement une première couche semiconductrice (5) ayant une première énergie de bande interdite, une couche semiconductrice tampon (6), une deuxième couche semiconductrice (7) ayant une deuxième énergie de bande interdite différente de la première énergie de bande interdite. Deux photodétecteurs (1, 2) sensibles à deux couleurs différentes sont formés respectivement au moyen de la première et de la deuxième couches semiconductrices (5, 7). Un premier plot de polarisation (9) relie électriquement la première couche semiconductrice (5) au premier circuit de polarisation (8b, 14). Un deuxième plot de polarisation (10) relie électriquement la deuxième couche semiconductrice (7) à un deuxième circuit de polarisation (8a, 15). Le premier plot de polarisation (10) étant dépourvu de connexion électrique avec la seconde couche semiconductrice (7).

## Description

### Domaine technique de l'invention

L'invention est relative à un dispositif de détection comportant un premier photodétecteur sensible à une première couleur et un deuxième photodétecteur sensible à une deuxième couleur, les deux photodétecteurs pouvant fonctionner simultanément.

### État de la technique

Dans le domaine des dispositifs de détection, il y a communément un photodétecteur associé à un circuit de lecture. Le photodétecteur délivre un signal représentatif de la scène observée et ce signal est traité par le circuit de lecture.

La transformation du signal électromagnétique en un signal électrique représentatif est obtenue au moyen de la polarisation du photodétecteur dans une gamme de tensions particulière. La polarisation du photodétecteur est obtenue au moyen du potentiel de substrat imposé sur une première borne du photodétecteur. La polarisation du photodétecteur est également obtenue au moyen d'un potentiel de référence imposé sur une seconde borne du photodétecteur, par exemple par un dispositif de lecture de type amplificateur transimpédance capacitif.

Afin d'obtenir toujours plus d'information sur la scène observée, le photodétecteur a été associé à un photodétecteur additionnel qui est sensible à une autre couleur. Le photodétecteur additionnel est également polarisé au moyen du substrat et au moyen de sa deuxième borne reliée à un deuxième circuit de lecture. De cette manière, la même scène peut fournir deux informations différentes selon que l'information provienne du premier photodétecteur ou du deuxième photodétecteur, si la scène émet deux signaux différents dans deux couleurs différentes. Un tel photodétecteur est décrit dans le document US 6,034,407.

Bien que les deux photodétecteurs soient configurés pour réagir avec des longueurs d'ondes différentes, on observe que cette configuration du dispositif est particulièrement sensible aux phénomènes d'illuminations parasites ou crosstalk en anglais. On constate que l'information contenue dans la longueur d'onde associée à l'un des deux photodétecteurs peut se retrouver partiellement dans le signal stocké dans le circuit de lecture associé à l'autre photodétecteur ce qui limite l'intérêt de cette architecture car les signaux sont mélangés.

### Objet de l'invention

On constate qu'il existe un besoin de prévoir un dispositif de détection qui est moins sensible au mélange des informations contenues dans les deux couleurs associées aux deux photodétecteurs.

On tend à combler ce besoin au moyen d'un dispositif qui comporte :
- un substrat comportant successivement une première couche semiconductrice ayant une première énergie de bande interdite, une couche semiconductrice tampon, une deuxième couche semiconductrice ayant une deuxième énergie de bande interdite différente de la première énergie de bande interdite,
- une première photodiode sensible à une première couleur et ayant une première électrode formée au moyen de la première couche semiconductrice,
- une deuxième photodiode sensible à une deuxième couleur et ayant une première électrode formée au moyen de la deuxième couche semiconductrice et séparée de la première photodiode par la couche tampon,
- un circuit de lecture couplé électriquement aux première et seconde photodiodes,
- un premier plot de polarisation connecté électriquement à la première couche semiconductrice et dépourvu de connexion électrique avec la seconde couche semiconductrice,
- un premier contact relié à la deuxième électrode de la première photodiode,
- un deuxième contact relié à la deuxième électrode de la deuxième photodiode et séparé du premier contact par la couche tampon,
- un deuxième plot de polarisation connecté électriquement à la deuxième couche semiconductrice et dépourvu de connexion électrique avec la première couche semiconductrice,
- un premier circuit de polarisation configuré pour appliquer une première différence de potentiel entre le premier plot de polarisation et le premier contact,
- un deuxième circuit de polarisation configuré pour appliquer une deuxième différence de potentiel entre le deuxième plot de polarisation et le deuxième contact,
dispositif dans lequel la couche tampon est configurée pour bloquer le passage d'un courant de porteurs de charge entre les deux couches semi-conductrices et séparer électriquement les deux photodiodes.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en coupe, un dispositif de détection muni de deux photodétecteurs,
- la figure 2 représente, de manière schématique, en vue dessus, un dispositif de détection muni de plusieurs groupes de deux photodétecteurs associés à un deuxième plot de polarisation dans différentes configurations
- la figure 3 représente de façon schématique une représentation électriques des photodiodes du dispositif de détection.

### Description de modes de réalisation préférentiels de l'invention

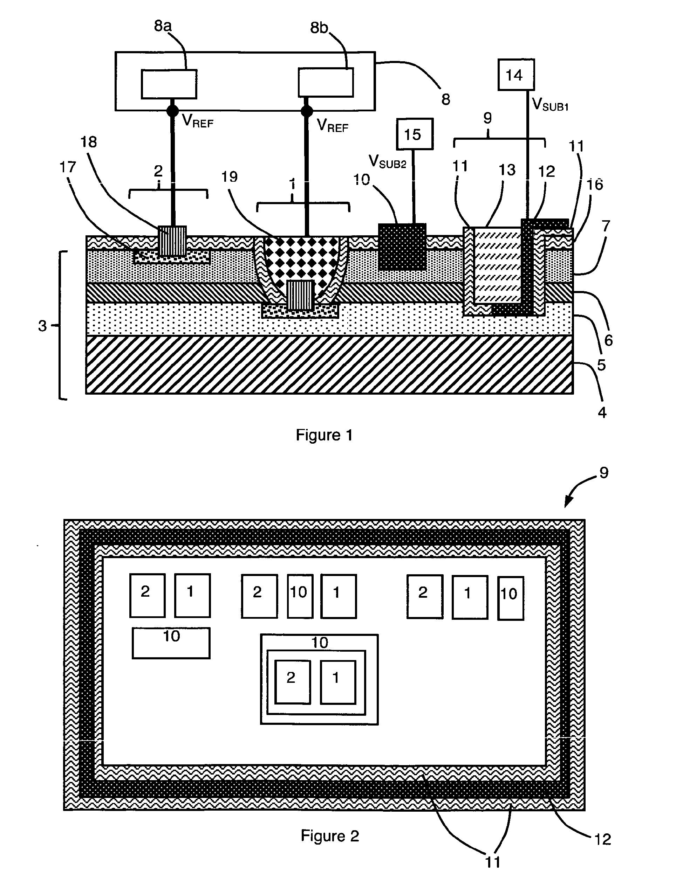

Comme cela est illustré à la figure 1, le dispositif de détection comporte un premier photodétecteur 1 sensible à une première couleur et un deuxième photodétecteur 2 sensible à une deuxième couleur différente de la première couleur. Le premier 1 et le deuxième 2 photodétecteurs sont formés sur un substrat 3. Le substrat 3 comporte successivement un support 4, une première couche semiconductrice 5 présentant une première valeur de bande interdite, une couche tampon 6 semiconductrice et une deuxième couche semiconductrice 7 présentant une deuxième valeur de bande interdite différente de la première valeur.

De manière préférentielle, la première valeur de bande interdite est supérieure à la deuxième valeur de bande interdite afin de favoriser l'efficacité de la collection du rayonnement incident lorsque celui-ci traverse la première couche semiconductrice 5 pour atteindre ensuite la deuxième couche semiconductrice 7.

De manière encore plus préférentielle, le support est transparent aux deux couleurs associées respectivement au premier photodétecteur 1 et au deuxième photodétecteur 2 afin de favoriser la collection de la lumière via le support. Le support est, par exemple, réalisé dans un matériau semi-conducteur ayant une énergie de bande interdite qui est supérieure à l'énergie de bande interdite de la première couche semiconductrice 5 et de la deuxième couche semiconductrice 7.

Dans un mode de réalisation particulier qui peut être combiné avec les modes de réalisation précédents, la couche tampon 6 est également transparente aux couleurs du premier photodétecteur 1 et du deuxième photodétecteur 2. La couche tampon 6 est, par exemple, réalisée dans un matériau semi-conducteur ayant une énergie de bande interdite qui est supérieure à l'énergie de bande interdite de la première couche semiconductrice 5 et de la deuxième couche semiconductrice 7.

Le premier photodétecteur 1 est formé en partie par la première couche semiconductrice 5 et le deuxième photodétecteur 2 est formé en partie par la deuxième couche semiconductrice 7. Le premier 1 et le deuxième 2 photodétecteurs sont décalés latéralement, c'est-à-dire que la zone de collection du premier photodétecteur 1 est distincte de la zone de collection du deuxième photodétecteur 2, en vue de dessus et en coupe.

Dans un mode de réalisation particulier, le premier photodétecteur 1 et le deuxième photodétecteur 2 sont tous les deux des photodiodes. Dans ce cas une première diode est formée dans la première couche semiconductrice 5 et une seconde diode est formée dans la deuxième couche semiconductrice 7. Les deux diodes sont décalées latéralement l'une de l'autre afin de former une architecture semi-planaire (dans un plan parallèle à l'interface entre la couche 5 et la couche 6).

Les deux photodétecteurs sont reliés à un circuit de lecture 8 qui reçoit le signal de chacun des photodétecteurs 1, 2 afin d'intégrer ces signaux, de les stocker et/ou de les analyser pour les envoyer ensuite à un circuit de traitement.

Dans un mode de réalisation particulier, le dispositif de détection comporte une matrice de détection qui est formée, sur le substrat 3, par une pluralité de premiers photodétecteurs 1 et par une pluralité de deuxièmes photodétecteurs 2. De manière avantageuse, il y a autant de premiers photodétecteurs 1 que de deuxièmes photodétecteurs 2. De manière encore plus avantageuse, un premier photodétecteur 1 est disposé à proximité immédiate d'un deuxième photodétecteur 2 et les deux photodétecteurs sont organisés de la même manière avec le ou les mêmes pas de répétition entre deux premiers photodétecteurs et entre deux deuxièmes photodétecteurs dans la ou les directions d'organisation de la matrice de détection.

Dans ce cas de figure, la matrice de détection est associée à un circuit de lecture 8 qui comporte une pluralité de dispositifs de lecture 8a, 8b qui sont connectés aux photodétecteurs. Un photodétecteur est relié à un dispositif de lecture 8a, 8b de manière à récupérer le signal émis par le photodétecteur. Le dispositif de lecture 8a est couplé au premier photodétecteur 1 pour récupérer le signal émis. Le dispositif de lecture 8b est couplé au deuxième photodétecteur 2 pour récupérer le signal émis.

Le dispositif de détection comporte un premier circuit de polarisation du premier photodétecteur 1. Le premier circuit de polarisation est configuré de manière à imposer une première différence de potentiel entre les bornes du premier photodétecteur 1. Cette première valeur de différence de potentiel est configurée pour obtenir une première condition de transformation du signal optique reçu en un signal électrique, par exemple un premier coefficient de conversion du flux lumineux reçu en un courant généré. A titre d'exemple, lorsque les photodétecteurs sont des photodiodes, la polarisation est configurée pour polariser la photodiode en inverse.

Le dispositif de détection comporte un deuxième circuit de polarisation du deuxième photodétecteur 2. Le deuxième circuit de polarisation est configuré de manière à imposer une deuxième différence de potentiel entre les bornes du deuxième photodétecteur 2. De préférence, la deuxième différence de potentiel est différente de la première différence de potentiel. Cette deuxième valeur de différence de potentiel est configurée pour obtenir une deuxième condition de transformation du signal optique reçu en un signal électrique, par exemple un deuxième coefficient de conversion qui peut être différent du premier coefficient de conversion.

Dans un mode de réalisation particulier, les première et deuxième conditions de polarisation sont différentes, de manière à faire fonctionner le premier photodétecteur 1 ou le deuxième photodétecteur 2 dans un mode de fonctionnement différent de l'autre photodétecteur. A titre d'exemple, l'un des deux photodétecteurs est soumis à une polarisation plus importante que l'autre photodétecteur, de manière à former un photodétecteur à avalanche, l'autre photodétecteur ayant un fonctionnement plus linéaire entre le signal reçu et le signal émis.

La polarisation des deux photodétecteurs est réalisée en imposant deux potentiels différents sur leurs deux bornes. Une première borne du photodétecteur est formée par le substrat et une deuxième borne est formée par un contact électrique 18 disposé sur le substrat face au photodétecteur.

La première borne du photodétecteur est formée par le substrat 3 et plus particulièrement par la couche semiconductrice associée au photodétecteur. Un potentiel de substrat V_{SUB} est imposé à la première borne par une source de tension via la couche semiconductrice associée et un plot de polarisation.

La deuxième borne est reliée électriquement au circuit de lecture 8 qui peut être utilisé pour imposer un potentiel de référence V_{REF}. Le potentiel de référence V_{REF} peut également être appliqué par un autre circuit ou par une combinaison du circuit de lecture 8 et d'un autre circuit.

Le circuit de polarisation du premier photodétecteur 1 comporte une première source de tension 14 et un premier dispositif de lecture 8b ou un autre circuit (non représenté). Le circuit de polarisation du deuxième photodétecteur 2 comporte une deuxième source de tension 15 et un deuxième dispositif de lecture 8a ou un autre circuit (non représenté).

Un premier potentiel de substrat V_{SUB1} est appliqué dans le substrat 3 par la première source de tension 14 via la première couche semiconductrice 5 et un premier plot de polarisation 9. Un deuxième potentiel de substrat V_{SUB2} est appliqué dans le substrat 3 par la deuxième source de tension 15 via la deuxième couche semiconductrice 7 et un deuxième plot de polarisation 10.

La couche tampon 6 est une couche qui n'autorise pas le passage d'un courant de porteurs de charge ou qui limite très fortement le passage des porteurs de charge. La couche tampon 6 peut être soumise à une différence de potentiel sans permettre le passage des porteurs de charge. La couche tampon 6 est avantageusement une couche semiconductrice intrinsèque (non intentionnellement dopée) qui présente une énergie de bande interdite supérieure à celles des première et deuxième couches semi-conductrices.

Les premier et deuxième plots de polarisation 9 et 10 sont réalisés, de préférence, avec un matériau faiblement résistif comme un matériau métallique pour faciliter l'évacuation des charges.

Le premier plot de polarisation 9 relie électriquement le premier circuit de polarisation à la première couche semiconductrice 5. Le premier plot 9 est dépourvu de connexion électrique avec la deuxième couche semiconductrice 7 ce qui empêche un transfert de charges entre les deux photodétecteurs et/ou entre les deux circuits de lecture 8b, 8a. Le premier plot 9 s'enfonce dans le substrat 3 pour venir connecter électriquement la première couche semiconductrice 5.

Dans un mode de réalisation particulier qui peut être combiné avec les modes de réalisation précédents, le substrat 3 comporte avantageusement un premier trou borgne avec un fond et au moins une paroi latérale. Le premier trou s'enfonce dans la deuxième couche semiconductrice 7 et la couche tampon 6 pour s'arrêter à la surface ou à l'intérieur de la première couche semiconductrice 5 ou du support 4. De manière préférentielle, le premier trou s'arrête à l'intérieur de la première couche semiconductrice 5 afin d'obtenir une résistance de contact réduite, le fond du premier trou est formé dans la première couche semiconductrice 5. Le substrat 3 comporte des parois latérales qui définissent le premier trou et qui sont au moins partiellement recouvertes par un matériau électriquement isolant 11 de manière à empêcher un court-circuit avec la deuxième couche semiconductrice 7.

Le deuxième plot de polarisation 10 relie électriquement le deuxième circuit de polarisation à la deuxième couche semiconductrice 7. Le deuxième plot 10 est dépourvu de contact électrique avec la première couche semiconductrice 5. Le deuxième plot 10 peut être disposé à la surface du substrat 3 ou il peut s'enfoncer dans le substrat 3 qui comporte, par exemple, un deuxième trou borgne avec un fond et au moins une paroi latérale. Le deuxième plot 10 est dépourvu d'interface électriquement conductrice avec la première couche semiconductrice 5 et avec la couche tampon 6. Le deuxième trou peut s'arrêter à la surface ou à l'intérieur de la deuxième couche semiconductrice 7. De manière préférentielle, le deuxième trou s'arrête à l'intérieur de la deuxième couche semiconductrice 7 afin d'obtenir une résistance de contact réduite. Les parois latérales du deuxième trou sont préférentiellement dépourvues de matériau électriquement isolant afin d'obtenir une surface de contact électrique importante entre la deuxième couche semiconductrice 7 et le deuxième plot de contact 10 lorsque le deuxième trou s'arrête dans la couche 7.

Il a été découvert que cette architecture particulière avec deux plots de polarisation distincts associés respectivement au premier photodétecteur 1 et au deuxième photodétecteur 2 permet d'avoir un dispositif de détection plus robuste en cas de forte illumination avec une très forte réduction du mélange des deux signaux envoyés.

Dans l'art antérieur, un seul plot métallique relie électriquement les deux couches semiconductrices avec un potentiel de substrat commun. Dans cette configuration, les inventeurs ont observé que quand un des deux photodétecteurs est soumis à une illumination importante, la polarisation de la couche semiconductrice est modifiée et une partie des charges électriques générées par le photodétecteur est envoyée dans l'autre couche semiconductrice qui se trouve à un potentiel différent. De cette manière, l'un des deux dispositifs de lecture reçoit plus de charges électriques et l'autre dispositif de lecture reçoit moins de charges électrique ce qui fausse l'analyse de la scène observée.

Au moyen d'une architecture dépourvue de contact électrique commun entre la première couche semiconductrice 5 et la deuxième semiconductrice 7, il est possible de réduire voire de s'affranchir de cet échange de charges électriques. Les premières et deuxièmes photodiodes ne partagent aucun contact électrique ce qui permet de dissocier les signaux électriques fournis par chacune des photodiodes.

Par exemple, le document EP 0747962 décrit une structure avec deux photodiodes possédant une anode commune. Dans cette configuration, les deux photodiodes mélangent leurs signaux respectifs lors d'un fonctionnement en simultané.

Dans un mode de réalisation préférentiel pouvant être combiné aux modes précédents, dans une matrice de détection, un deuxième plot 10 est associé à chaque deuxième photodétecteur 2 afin d'assurer l'homogénéité des conditions de polarisation dans toute la matrice de détection. Il y a donc autant de deuxièmes photodétecteurs 2 que de deuxièmes plots 10. Le substrat impose la tension V_{SUB2} sur la première borne et le circuit de mesure impose la tension V_{REF}.

Comme illustré à la figure 2, le deuxième plot 10, peut avoir une forme quelconque, par exemple carrée, ou circulaire. Le deuxième plot 10 peut être placé d'un côté des deux photodétecteurs ou entre les deux photodétecteurs. Le deuxième plot 10 peut être dans l'alignement des deux photodétecteurs et séparé du premier photodétecteur 1 par le second photodétecteur 2 ou inversement. Dans un autre cas de figure, le deuxième plot 10 n'est pas aligné avec les deux photodétecteurs et le deuxième plot 10 fait face à l'un des deux photodétecteurs ou aux deux photodétecteurs selon une direction qui est sensiblement perpendiculaire à l'axe passant par les deux photodétecteurs. Dans un mode de réalisation particulier, le deuxième plot 10 forme une tranchée fermée autour des deux photodétecteurs pour faciliter l'évacuation des charges. En vue de dessus ou de dessous, la tranchée fermée à la forme d'un anneau dont le centre est rempli par les deux photodétecteurs.

De manière encore plus préférentielle, le premier plot 9 est commun à plusieurs premiers photodétecteurs 1. Comme le premier plot 9 est réalisé à travers la deuxième couche 7 et la couche tampon 6, la surface occupée par le premier trou est importante. La mutualisation du premier plot 9 avec plusieurs premiers photodétecteurs 1 permet de conserver une densité d'intégration importante. Il y a donc moins de premiers plots 9 que de premiers photodétecteurs 1. Avantageusement, le premier trou associé au premier plot a la forme d'une tranchée fermée qui délimite une surface fermée, une première zone du substrat qui contient plusieurs premiers photodétecteurs 1. En vue de dessus ou de dessous, la tranchée fermée à la forme d'un anneau dont le centre est rempli par plusieurs premiers photodétecteurs 1, par plusieurs deuxièmes photodétecteurs 2 et plusieurs plots 10. La première zone du substrat est définie par une première paroi latérale qui est commune avec celle de la tranchée. En d'autres termes, le trou borgne définit une tranchée fermée en forme d'anneau délimitant une première zone de la première couche semiconductrice 5 et de la deuxième couche semiconductrice 7. Une pluralité de premiers photodétecteurs 1 et une pluralité de deuxièmes photodétecteurs 2 sont disposés dans cette première zone. De manière préférentielle, plusieurs deuxièmes plots de polarisation sont disposés dans la première zone.

Dans un mode de réalisation particulièrement intéressant, le trou du premier plot 9 est une tranchée fermée qui forme un anneau autour de la matrice de détection, dans le substrat 3. Tous les premiers photodétecteurs 1 de la matrice sont à l'intérieur de la surface délimitée par la tranchée du premier plot 9. Il y a un seul premier plot 9 pour l'ensemble de la matrice de détection. De manière avantageuse, le premier plot de polarisation 9 forme un anneau autour de la matrice de détection afin d'homogénéiser les conditions de polarisation.

Dans un mode de réalisation particulier qui peut être combiné avec les modes de réalisation précédents, le premier circuit de polarisation est configuré de manière à appliquer une polarisation plus importante sur le premier photodétecteur 1 que sur le deuxième photodétecteur 2. De manière encore plus préférentielle, le premier circuit de polarisation est configuré de manière à faire fonctionner le premier photodétecteur 1 comme un photodétecteur à avalanche.

Il est important de former un premier plot de polarisation 9 qui est bien isolé électriquement de la deuxième couche semiconductrice 7 et dont la structure est robuste vis-à-vis des aléas de fabrication. Cette isolation électrique entre les deux couches est particulièrement intéressante lorsque des différences de polarisation importantes sont appliquées entre les deux types de photodétecteurs et qu'un court-circuit peut détériorer voire détruire un des deux photodétecteurs.

Le premier trou du premier plot 9 de polarisation comporte un fond et au moins une parois latérale. Le fond est formé par la première couche semiconductrice 5. De manière avantageuse, le fond du premier trou est disposé à l'intérieur de la première couche semiconductrice 5 et non à la surface de cette couche afin d'avoir une meilleure robustesse du procédé de réalisation vis-à-vis des aléas de production.

La ou les parois latérales du premier trou sont partiellement recouvertes par un matériau électriquement isolant 11 afin que la deuxième couche semiconductrice 7 et la couche tampon 6 présentent une interface avec le matériau électriquement isolant 11. De manière avantageuse, toutes les parois latérales du premier trou sont complètement recouvertes par le matériau électriquement isolant 11 afin d'avoir un dispositif robuste dont la probabilité d'avoir un court-circuit avec les couches 6 et 7 est limitée. Lorsque le trou s'enfonce dans la première couche semiconductrice 5, il est avantageux de laisser le matériau électriquement isolant 11 sur la paroi latérale du trou afin qu'il existe une interface entre la couche 11 et la première couche semiconductrice 5. De cette manière, les risques de court-circuit par les parois latérales à l'interface entre la couche tampon 6 et la première couche semiconductrice 5 sont réduits.

Le fond du premier trou est partiellement recouvert par le matériau électriquement isolant 11 et la partie recouverte est localisée dans le prolongement des parois latérales. En coupe, la couche électriquement isolante 11 à la forme d'un L sur la figure 1. De manière à favoriser une surface de contact importante entre la première couche semiconductrice 5 et un film électriquement conducteur 12 débouchant à la surface du premier trou et conserver un procédé robuste, la surface de contact entre le film électriquement conducteur 12 et la couche semiconductrice 5 est plus petite que la surface du fond du trou. De manière encore plus préférentielle, la surface de contact entre le film 12 et la couche 5 est plus petite que le fond du premier trou de manière à former une zone de garde recouverte par le film électriquement isolant 11 dans le fond du premier trou.

De manière préférentielle, le film électriquement conducteur 12 recouvre partiellement les parois latérales du premier trou de manière à réduire la surface de contact entre le film électriquement isolant 11 et le film électriquement conducteur 12. Cette limitation de la surface de recouvrement du film 12 sur le film 11 permet de réduire la probabilité de court-circuit à travers le film 11 si ce dernier est défaillant et de rendre le procédé de réalisation plus robuste. Le film électriquement conducteur 12 déborde avantageusement de la tranchée pour recouvrir la face supérieure du substrat hors de la première zone ce qui permet un contact électrique facilité et sûr.

Lorsque le premier plot 9 est associé à une tranchée fermée formant un anneau autour d'un groupe de photodétecteurs, il y a une première paroi latérale adjacente aux photodétecteurs, la paroi interne, et une deuxième paroi latérale opposée dans le substrat 3, la paroi externe. Les deux parois sont reliées par le fond de la tranchée.

En d'autres termes, le substrat 3 comporte une première face latérale définissant la première zone et une deuxième face latérale opposée à la première face latérale.

Un film électriquement conducteur 12 est formé dans le fond du trou et il s'étend le long de la paroi externe opposée à la paroi interne. Dans un plan de coupe parallèle à l'interface entre la couche tampon 6 et la première couche semiconductrice 5, le film électriquement isolant 11 recouvrant la paroi externe est séparé du film électriquement isolant 11 recouvrant la paroi interne au moyen du film électriquement conducteur 12. Le film électriquement conducteur 12 est séparé du deuxième photodétecteur 2 par le film électriquement isolant 11 et par un matériau électriquement isolant additionnel 13. Le matériau électriquement isolant 13 peut être une zone vide ou un gaz. Le matériau électriquement isolant 13 peut également être un matériau déposé dans le premier trou sur le matériau électriquement isolant 11 et sur le matériau électriquement conducteur 12. Les matériaux 11 et 13 peuvent avoir des compositions chimiques identiques. En d'autres termes, la tranchée présente successivement dans un plan de coupe parallèle à l'interface entre la couche tampon 6 et la première couche semiconductrice 5, depuis la paroi externe vers la paroi interne, un film électriquement isolant 11, le film électriquement conducteur 12, un matériau 13 électriquement isolant déposé sur le film électriquement conducteur 12 et le film électriquement isolant 11.

Dans une variante de réalisation préférentielle qui peut être combinée avec le mode de réalisation précédent et illustrée à la figure 1, la surface de connexion entre la première couche semiconductrice 5 et le film conducteur 12, dans le fond du premier trou, est décalée vers la paroi externe de manière à avoir une zone de garde recouverte par le film électriquement isolant 11.

Dans ce cas de figure, en vue de dessus, dans le fond du premier trou, il y a un premier anneau en matériau électriquement isolant 11 qui est entouré par un deuxième anneau en matériau électriquement conducteur 12. Ainsi, même en cas de problème de fabrication du matériau électriquement isolant 11 sur les parois latérales, la partie de la deuxième couche semiconductrice 7 délimitée par la tranchée fermée du premier plot 9 n'est pas en contact électrique avec le film 12. Les deux anneaux entourent la première zone du substrat 3 qui comprend avantageusement une pluralité de premiers photodétecteurs et une pluralité de deuxièmes photodétecteurs.

Ce mode de réalisation est particulièrement intéressant lorsque la tranchée du premier plot 9 est formée autour de la matrice. Dans ce cas, il n'y a pas de risque de court-circuit entre les deux couches semi-conductrices dans la matrice.

Dans ce mode de réalisation, il peut même être envisagé d'éliminer la couche électriquement isolante 11. La partie de la deuxième couche semiconductrice 7 qui est en contact électrique avec la première couche 5 ne possède pas de deuxième photodétecteur 2 et n'est pas reliée à un circuit de lecture 8.

Le film électriquement conducteur 12 débouche avantageusement hors du premier trou afin de former un contact pour le premier circuit de polarisation. Le film électriquement conducteur 12 est séparé de la surface du substrat par une couche électriquement isolante 16 afin d'éviter un court-circuit avec la deuxième couche semiconductrice 7 depuis sa face supérieure.

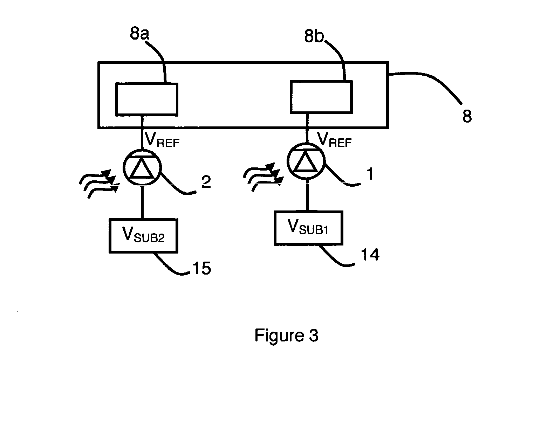

Dans le mode de réalisation particulier illustré aux figures 1 et 3, les photodétecteurs 1 et 2 sont tous les deux des photodiodes. La première couche semiconductrice 5 est d'un premier type de conductivité et il existe dans cette dernière une zone dopée d'un deuxième type de conductivité 17 afin de former la diode du premier photodétecteur 1. Il en va de même pour former la diode du deuxième photodétecteur 2 dans la deuxième couche semiconductrice 7. Les deux photodiodes alors la même orientation Anode-Cathode, vis-à-vis de l'empilement de couche ou du sens d'arrivé du rayonnement incident. De manière avantageuse, la première couche semiconductrice 5 et la deuxième semiconductrice 7 sont du même type de conductivité afin de pouvoir fonctionner simultanément et analyser la même scène observée. De manière préférentielle, les deux photodétecteurs comporte un contact 18, 19 qui est métallique ou à base de métal afin de réduire la résistance d'accès du dispositif. Le contact 18, 19 est relié électriquement à la zone dopée 17 de manière à définir partiellement la polarisation de la photodiode. Cependant, il est également envisageable d'avoir des première et seconde couches semi-conductrices avec des types de conductivités opposés, mais ce mode de réalisation est plus sensible à la qualité isolante de la couche tampon.

Comme représenté à la figure 3, les deux photodiodes sont dissociées électriquement de manière à avoir une dissociation des conditions d'alimentation et des signaux fournis par les photodiodes.

Dans un mode de réalisation particulier, le support 4 peut être éliminé ou il peut présenter une épaisseur réduite pour limiter les contraintes thermomécaniques.

Le dispositif peut être réalisé avec les techniques classiques par exemple en formant le substrat 3 avec ses différentes couches. Puis les photodétecteurs sont formés. La tranchée du plot 9 et le plot 9 sont formés. Les photodétecteurs peuvent être formés avant ou après les trous. Il est encore possible de former les trous durant le procédé de formation des photodétecteurs. Le premier photodétecteur est formé au moyen d'un trou s'enfonçant jusqu'à la première couche semiconductrice 5 puis au moyen d'un contact électrique ressortant le signal. La couche isolante 11 peut être déposée simultanément dans le trou du contact 9 et dans le trou du premier photodétecteur.

Les différentes couches du substrat sont avantageusement monocristallines afin de favoriser les performances électriques du dispositif de détection. De manière avantageuse, les différentes couches semi-conductrices sont en accord de paramètre de maille de manière à former un ensemble monobloc favorisant un bon maintien thermomécanique et une bonne répartition de la chaleur ou du froid. A titre d'exemple, le support peut être en CdZnTe et les autres couches semi-conductrices sont en HgCdTe. Cependant, d'autres matériaux sont envisageables. De manière avantageuse, les différentes couches semi-conductrices sont formées par épitaxie, par exemple par épitaxie par jet moléculaire ou par épitaxie par voie liquide.

## Revendications

1. Dispositif de détection comportant :
- un substrat (3) comportant successivement
- une première couche en semiconductrice (5) ayant une première énergie de bande interdite,
- une couche tampon (6) en matériau semiconducteur,
- une deuxième couche semiconductrice (7) ayant une deuxième énergie de bande interdite différente de la première énergie de bande interdite,
- une première photodiode (1) sensible à une première couleur et ayant une première électrode formée au moyen de la première couche semiconductrice (5),
- une deuxième photodiode (2) sensible à une deuxième couleur et ayant une première électrode formée au moyen de la deuxième couche semiconductrice (7) et séparée de la première photodiode par la couche tampon (6),
- un circuit de lecture (8) couplé électriquement aux première et seconde photodiodes (1, 2),
dispositif **caractérisé en ce que** la couche tampon (6) est configurée pour bloquer le passage d'un courant de porteurs de charge entre les deux couches semi-conductrices (5, 7) et séparer électriquement les deux photodiodes (1, 2) et **en ce qu'**il comporte :
- un premier plot de polarisation (9) connecté électriquement à la première couche semiconductrice (5) et dépourvu de connexion électrique avec la seconde couche semiconductrice (7),
- un premier contact (19) relié à la deuxième électrode de la première photodiode (1),
- un deuxième contact (18) relié à la deuxième électrode de la deuxième photodiode (2) et séparé du premier contact (19) par la couche tampon (6),
- un deuxième plot de polarisation (10) connecté électriquement à la deuxième couche semiconductrice (7) et dépourvu de connexion électrique avec la première couche semiconductrice (5),
- un premier circuit de polarisation (8b, 14) configuré pour appliquer une première différence de potentiel entre le premier plot de polarisation (9) et le premier contact (19), et
- un deuxième circuit de polarisation (8a, 15) configuré pour appliquer une deuxième différence de potentiel entre le deuxième plot de polarisation (10) et le deuxième contact (18).

2. Dispositif selon la revendication 1, **caractérisé en ce que** le substrat (3) comporte un trou borgne ayant un fond formé dans la première couche semiconductrice (5), un film électriquement conducteur (12) s'enfonçant dans le substrat (3) à travers la deuxième couche semiconductrice (7) et la couche tampon (6) à l'intérieur du trou borgne pour le premier plot de polarisation (9) réalisant la connexion électrique entre une première source de tension (14) et le fond du trou.

3. Dispositif selon la revendication 2, **caractérisé en ce que** le trou borgne définit une tranchée fermée en forme d'anneau délimitant une première zone de la première couche semiconductrice (5) munie d'une pluralité de premiers photodétecteurs (1) et une première zone de la deuxième couche semiconductrice (7) munie d'une pluralité de deuxièmes photodétecteurs (2).

4. Dispositif selon la revendication 3, **caractérisé en ce qu'il** comporte une pluralité de deuxièmes plots de polarisation (10) disposés dans ladite première région de la deuxième couche semiconductrice (7).

5. Dispositif selon l'une des revendications 3 et 4, **caractérisé en ce que** le substrat (3) comporte une première face latérale définissant la première zone de la première couche semiconductrice (5) et une deuxième face latérale opposée à la première face latérale, la tranchée présentant successivement dans un plan de coupe parallèle à l'interface entre la couche tampon (6) et la première couche semiconductrice (5), depuis la deuxième face latérale vers la première face latérale, un film électriquement isolant (11), le film électriquement conducteur (12), un matériau électriquement isolant déposé sur le film électriquement conducteur et le film électriquement isolant (11).

6. Dispositif selon la revendication 5, **caractérisé en ce que** dans le fond du trou, le film électriquement isolant (11) définit un premier anneau entourant la première zone et **en ce que** le film électriquement conducteur (12) définit un deuxième anneau entourant le premier anneau.

7. Dispositif selon l'une quelconque des revendications 1 à 6, **caractérisé en ce que** le premier circuit de polarisation (8b, 14) est configuré pour délivrer une première différence de potentiel différente de la deuxième différence de potentiel.

8. Dispositif selon la revendication 7, **caractérisé en ce que** le premier circuit de polarisation (14, 8b) comporte une première source de tension (14) connectée électriquement au premier plot de polarisation (9) et configuré pour délivrer une première tension du substrat (V_{SUB1}) et **en ce que** le deuxième circuit de polarisation (15, 8a) comporte une deuxième source de tension (15) connectée électriquement au deuxième plot de polarisation (9) et configuré pour délivrer une deuxième tension du substrat (V_{SUB2}) différente de la première tension de substrat (V_{SUB1}).

9. Dispositif selon l'une quelconque des revendications 1 à 8, **caractérisé en ce que** le premier photodétecteur (1) est un photodétecteur à avalanche.

10. Dispositif selon l'une quelconque des revendications 1 à 9 **caractérisé en ce que** la deuxième énergie de bande interdite est inférieure à la première énergie de bande interdite.

11. Dispositif selon l'une quelconque des revendications 1 à 10 **caractérisé en ce que** le premier plot de polarisation (9) est dépourvu de contact électrique avec la couche tampon (6).
